(19) Europäisches Patentamt
European Patent Office
Office européen des brevets

(11) EP 2 219 242 A2

(12) EUROPEAN PATENT APPLICATION

(43) Date of publication:
18.08.2010 Bulletin 2010/33

(51) Int Cl.:
H01L 33/52 (2010.01)    H01L 33/54 (2010.01)
B29C 45/14 (2006.01)

(21) Application number: 10153757.9

(22) Date of filing: 17.02.2010

(84) Designated Contracting States:
AT BE BG CH CY CZ DE DK EE ES FI FR GB GR
HR HU IE IS IT LI LT LU LV MC MK MT NL NO PL
PT RO SE SI SK SM TR
Designated Extension States:
AL BA RS

(30) Priority: 17.02.2009 JP 2009033886
11.05.2009 JP 2009114786
20.05.2009 JP 2009122139

(71) Applicant: Nitto Denko Corporation
Ibaraki-shi,
Osaka 567-8680 (JP)

(72) Inventors:
• Hirokazu, Matsuda
Ibaraki-shi
Osaka (JP)

• Ryuichi, Kimura
Ibaraki-shi
Osaka (JP)
• Koji, Akazawa
Ibaraki-shi
Osaka (JP)
• Kazuya, Fujioka
Ibaraki-shi
Osaka (JP)
• Hideyuki, Usui
Ibaraki-shi
Osaka (JP)
• Suehiro, Ichiro
Ibaraki-shi
Osaka (JP)

(74) Representative: Grünecker, Kinkeldey,
Stockmair & Schwanhäusser
Anwaltssozietät
Leopoldstrasse 4
80802 München (DE)

(54) **Sheet for photosemiconductor encapsulation**

(57)    The present invention relates to a sheet for photosemiconductor encapsulation having a release sheet and an encapsulating resin layer laminated thereon, in which the release sheet contains a concave-convex portion-forming layer having a concave shape and/or a convex shape, at an interface with the encapsulating resin layer, and the encapsulating resin layer has a convex shape fitted to the concave shape of the release sheet and/or a concave shape fitted to the convex shape of the release sheet at an interface with the release sheet.

## FIG. 1

**Description**

**FIELD OF THE INVENTION**

The present invention relates to a sheet for photosemiconductor encapsulation. More particularly, the invention relates to a package for encapsulating a light-emitting element such as a light-emitting diode or a semiconductor laser, and relates to a sheet for photosemiconductor encapsulation which is easily mounted and can form a concave-convex shape on a surface thereof and a photosemiconductor apparatus encapsulated with the sheet.

**BACKGROUND OF THE INVENTION**

In place of incandescent lamps and fluorescent lamps, light-emitting devices of photosemiconductors (light-emitting diodes) have been have been widely applied. The light-emitting device has a structure including a light-emitting element and a translucent encapsulating resin disposed on the element, and a light which has passed through the translucent encapsulating resin is output.

By scattering, the emitted light from the light-emitting element passes through the translucent encapsulating resin as it is, while when the light arrives at a surface of the translucent encapsulating resin at an incident angle of the critical angle or more, it is totally reflected to be absorbed by the resin, resulting in a corresponding decrease in luminance of the light-emitting device.

In regard to this, JP-A-11-204840 discloses a technique of smoothing a part positioned above a light-emitting element, of a surface of an encapsulating resin, and roughening the remaining part, thereby outputting a light, regardless of the critical angle.

In a light-emitting device of JP-A-2005-166941, using as a mold a metal substrate on which concave and convex portions are formed, a translucent material is formed to form concave and convex portions having an approximately pyramid shape or an approximately conical shape on a surface of the translucent material, thereby increasing light extraction efficiency.

JP-A-2007-110053 discloses a photosemiconductor constituted by a plurality of resin layers, in which at least one of the resin layers is a concave-convex-shaped layer on which concave and convex portions are formed, and the concave-convex-shaped layer is laminated so as to become an interface between the other resin layers.

**SUMMARY OF THE INVENTION**

The concave-convex shape of the surface of the encapsulating resin layer in JP-A-11-204840 and JP-A-2005-166941 is transfer molded by using a mold in which a concave-convex shape is previously formed, after the light-emitting element has been encapsulated. A common mold is metal in material and has a planar structure. Further, the encapsulating resin layer is formed depending on the shape of the light-emitting element or a device on which the light-emitting element is mounted, so that it has no planar surface in many cases. Accordingly, it is not easy to form the concave-convex shape on the resin layer after encapsulation, and the concave-convex shape of the mold is not transferred as it is, also resulting in a complicated process.

Further, the light-emitting device is mounted after the concave-convex shape has been formed on the encapsulating resin layer. In that case, the concave-convex shape is in an exposed state, so that the surface gets scratched, or the concave-convex shape is lost, during a mounting operation, to fail to maintain the concave-convex shape of the mold, thereby decreasing light extraction efficiency.

The sheet for photosemiconductor encapsulation shown in JP-A-2007-110053 can increase reflection efficiency in the encapsulating resin layers. However, an interface at which the sheet comes into contact with the air is flat, so that the critical angle due to the difference in reflective index from the air is restricted to cause internal reflection due to Fresnel reflection, thereby failing to obtain sufficient light extraction efficiency.

An object of the invention is to provide a sheet for photosemiconductor encapsulation having excellent light extraction efficiency, and a photosemiconductor apparatus encapsulated with the sheet. Further, another object of the invention is to provide a sheet for photosemiconductor encapsulation in which a concave-convex shape of a mold is satisfactorily transferred and the concave-convex shape is maintained also after encapsulation processing, and a photosemiconductor apparatus encapsulated with the sheet. Furthermore, a further object of the invention is to provide a sheet for photosemiconductor encapsulation having excellent light extraction efficiency, in which concave-convex shapes of a release sheet and an encapsulating resin layer are fitted to each other with no space therebetween and the concave-convex shape is maintained also after encapsulation processing, and a photosemiconductor apparatus encapsulated with the sheet.

That is to say, the invention relates to the following (1) to (6).

(1) A sheet for photosemiconductor encapsulation comprising a release sheet and an encapsulating resin layer laminated thereon,

in which the release sheet includes a concave-convex portion-forming layer having a concave shape and/or a convex shape, at an interface with the encapsulating resin layer, and the encapsulating resin layer has a convex shape fitted to the concave shape of the release sheet and/or a concave shape fitted to the convex shape of the release sheet at an interface with the release sheet.

(2) The sheet for photosemiconductor encapsulation according to (1), in which the release sheet has a storage modulus at 150°C of 10 to 1,000 MPa and a sheet elongation at 150°C of 5.00% or less.

(3) The sheet for photosemiconductor encapsulation according to (1), in which the encapsulating resin layer includes: a concave-convex portion-forming layer having a convex shape fitted to the concave shape of the release sheet and/or a concave shape fitted to the convex shape of the release sheet; and an element embedding layer capable ob embedding a photosemiconductor element,

and in which the concave-convex portion-forming layer of the encapsulating resin layer has a storage modulus at 20°C of 6 to 1,500 MPa;

(4) The sheet for photosemiconductor encapsulation according to any one of (1) to (3), in which a height of the convex portion of the convex shape and/or a depth of the concave portion of the concave shape in the encapsulating resin layer is/are from 100 nm to 10 $\mu$m.

(5) The sheet for photosemiconductor encapsulation according to any one of (1) to (4), in which the release sheet further includes a support layer.

(6) A photosemiconductor apparatus in which a convex shape and/or a concave shape is/are formed on a surface thereof by laminating the sheet for photosemiconductor encapsulation according to any one of (1) to (5) on a photosemiconductor element-mounted substrate so that the encapsulating resin layer faces to the substrate; performing pressure molding; and then, separating the release sheet.

The sheet for photosemiconductor encapsulation of the invention achieves an excellent effect of being excellent in light extraction efficiency. Further, according to the sheet for photosemiconductor encapsulation of the invention, the concave-convex shape of the mold is satisfactorily transferred, and the concave-convex shape is maintained also after encapsulation processing. Consequently, it achieves the excellent effect of being excellent in light extraction efficiency. Furthermore, according to the sheet for photosemiconductor encapsulation of the invention, the concave-convex shapes of the release sheet and the encapsulating resin layer are fitted to each other with no space therebetween, and the concave-convex shape is maintained also after encapsulation processing, so that it achieves the excellent effect of being excellent in light extraction efficiency.

## BRIEF DESCRIPTION OF THE DRAWINGS

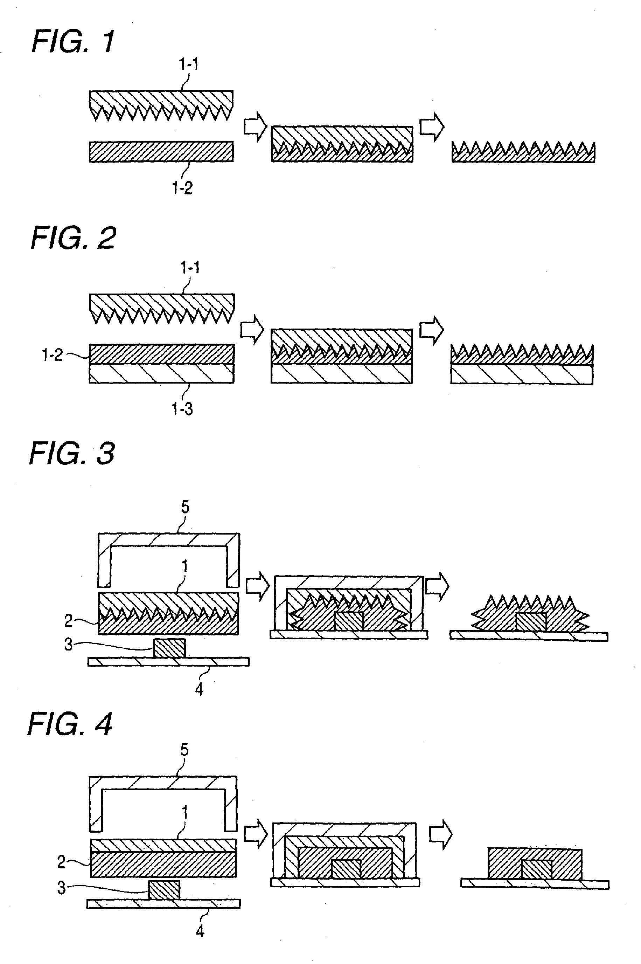

Fig. 1 is views showing one embodiment of forming concave portions on a release sheet (having a monolayer structure). The left view shows a state before formation of the concave portions, the middle shows a state at the time of mold transfer, and the right shows a state after the formation of the concave portions.

Fig. 2 is views showing one embodiment of forming concave portions on a release sheet (having a multilayer structure). The left view shows a state before formation of the concave portions, the middle shows a state at the time of mold transfer, and the right shows a state after formation of the concave portions.

Fig. 3 is views showing one embodiment of encapsulating a photosemiconductor element with a sheet for photosemiconductor encapsulation of an example of the invention. The left view shows a state before encapsulation, the middle shows a state at the time of compression molding, and the right shows a state after encapsulation.

Fig. 4 is views showing one embodiment of encapsulating a photosemiconductor element with a sheet for photosemiconductor encapsulation of a comparative example. The left view shows a state before encapsulation, the middle shows a state at the time of compression molding, and the right shows a state after encapsulation.

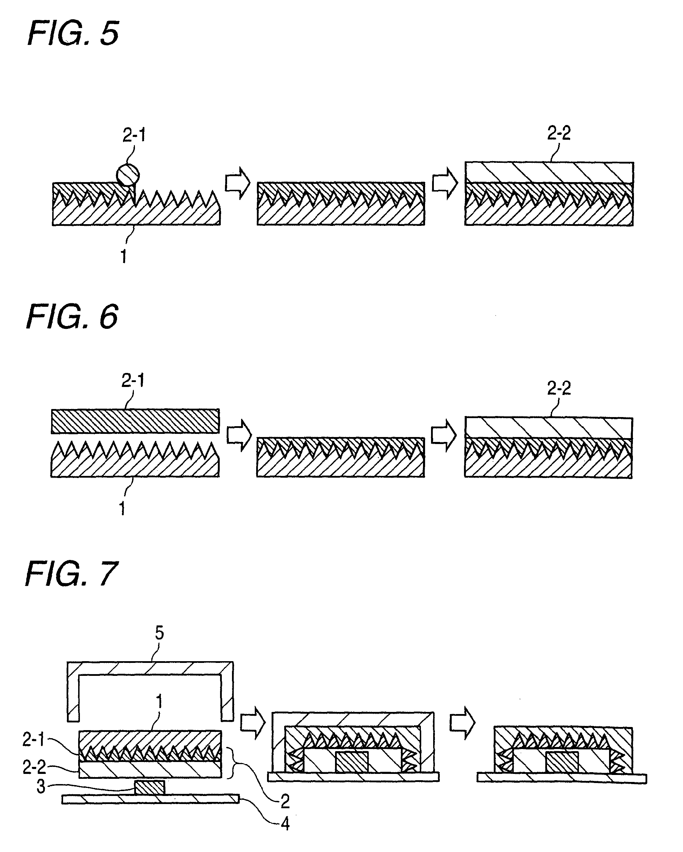

Fig. 5 is views showing one embodiment of forming an encapsulating resin layer on a release sheet. The left view shows a state where a resin solution for constituting a concave portion-forming layer is being applied, the middle shows a state where the concave portion-forming layer has been formed, and the right shows a state after an element embedding layer has been formed.

Fig. 6 is views showing another embodiment of forming an encapsulating resin layer on a release sheet. The left view shows a state before a concave portion-forming layer is laminated, the middle shows a state where the concave portion-forming layer has been formed, and the right shows a state after an element embedding layer has been formed.

Fig. 7 is views showing one embodiment of encapsulating a photosemiconductor element with a sheet for photosemiconductor encapsulation of an example of the invention. The left view shows a state before encapsulation, the middle shows a state at the time of compression molding, and the right shows a state after encapsulation.

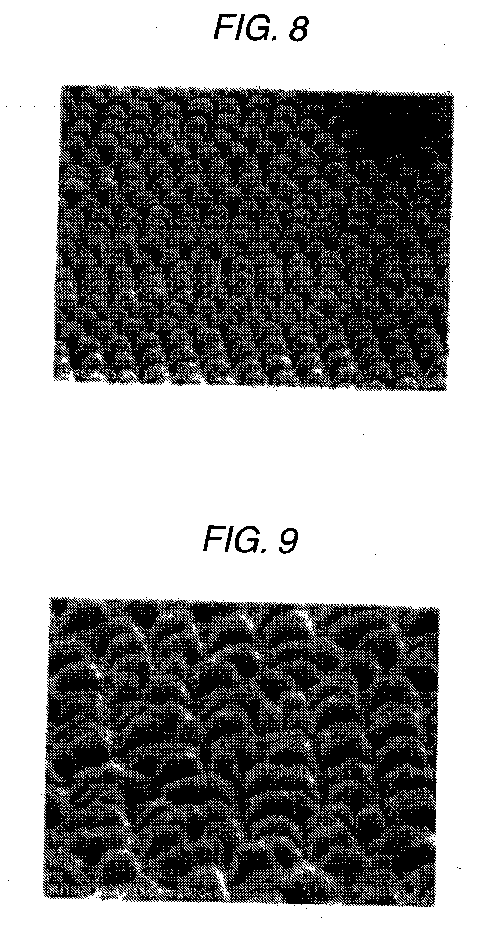

Fig. 8 is a view showing one embodiment of a concave-convex shape of an encapsulating resin layer in a sheet for photosemiconductor encapsulation of an example of the invention.

Fig. 9 is a view showing one embodiment of a concave-convex shape of an encapsulating resin layer in a sheet for photosemiconductor encapsulation of a comparative example.

Description of Reference Numerals and Signs

1-1    Mold for Forming Concave Portions on Release Sheet
1-2    Concave Portion-Forming Layer of Release Sheet
1-3    Support Layer of Release Sheet
1    Release Sheet
2-1    Concave-Convex Portion-Forming Layer of Encapsulating Resin Layer
2-2    Element Embedding Layer of Encapsulating Resin Layer
2    Encapsulating resin Layer
3    Photosemiconductor Element
4    Substrate
5    Mold for Compression Molding

## DETAILED DESCRIPTION OF THE INVENTION

The sheet for photosemiconductor encapsulation of the invention includes a release sheet and an encapsulating resin layer laminated thereon, in which the release sheet includes a concave-convex portion-forming layer having a concave shape and/or a convex shape, at an interface with the encapsulating resin layer, and the encapsulating resin layer has a convex shape fitted to the concave shape of the release sheet and/or a concave shape fitted to the convex shape of the release sheet at an interface with the release sheet. A structure of the sheet for photosemiconductor encapsulation of the invention will be described more specifically. At an interface between the release sheet and the encapsulating resin layer, the convex shape of the encapsulating resin layer is fitted to the concave shape of the release sheet, and/or the concave shape of the encapsulating resin layer is fitted to the convex shape of the release sheet. Thus, the encapsulating resin layer and the release sheet are laminated with each other with no space therebetween. Embodiments of encapsulating a photosemiconductor element by using the sheet having such a structure include an embodiment of first coating the light-emitting element with the sheet for photosemiconductor encapsulation of the invention; performing pressure molding; and then, separating the release sheet. After the separation of the release sheet, the convex shape and/or the concave shape (both shapes are hereinafter also collectively referred to as the concave-convex shape) of the encapsulating resin layer are exposed, and the concave-convex shape is positioned at an outermost layer of the encapsulating resin layer. The concave-convex shape makes it possible to output a light to the outside of the shape, regardless of an incident angle of the light emitted from the light-emitting element. Accordingly, formability of the concave-convex shape is conceivable to greatly contribute to improvement of light extraction efficiency. Incidentally, in this invention, the term "formability of the concave-convex shape" is an index indicating whether the concave-convex shape is formed to a desired shape or not, and "good formability" means that the concave-convex shape having the desired shape is formed.

In general, formation of the concave-convex shape on the sheet is performed by laminating the sheet with a mold having a shape fitted to a shape to be formed on the sheet and performing heating and pressurization from the above thereof. The shape of the mold is transferred to the sheet by the heating and pressurization. When the strength of the sheet is too high, the shape of the mold becomes difficult to be transferred, resulting in a decrease in formability of the concave-convex shape. Further, when the elongation of the sheet is too large, the sheet excessively elongates in the case of being pressurized from the above of the mold, and a surplus forms a crease or a streak, resulting in difficulty to obtain the desired concave-convex shape. Accordingly, in the invention, it has been found that the use of the release sheet having a specific strength and elongation improves the transfer from the mold to be able to form the desired concave-convex shape on the release sheet. Further, in addition to the fact that formability of the concave-convex shape on the release sheet is improved, it has also been found that by the release sheet having a specific strength and elongation, releasability of the release sheet is improved, that is to say, that the release sheet is separated without any breakage of the above-mentioned concave-convex shape at the time of separation thereof. Like this, formability of the concave-convex shape on the release sheet is good, and releasability is improved. As a result, it is conceivable that the desired concave-convex shape can also be formed on the encapsulating resin layer, consequently leading to improvement of light extraction efficiency.

Further, the concave-convex shape of the encapsulating resin layer may be formed by previously laminating the encapsulating resin layer with a mold having the desired concave-convex shape and performing heating and pressurization. However, in the sheet of the invention, the concave-convex shape of the encapsulating resin layer is preferably formed by using the release sheet as the mold, from the viewpoint that the concave-convex shape of the encapsulating resin layer and the concave-convex shape of the release sheet are fitted to each other with no space therebetween. In that case, it is conceivable that a resin which constitutes the concave-convex shape of the encapsulating resin layer, that is to say, a constituent resin of the concave-convex portion-forming layer of the encapsulating resin layer, has a great influence on formation and maintenance of the concave-convex shape. Accordingly, in the invention, it has been found that the concave-convex shape can be satisfactorily transferred following the concave-convex shape of the release sheet as the mold, and further that the concave-convex shape exposed after separation of the release sheet is maintained as it is, when the above-mentioned resin has a specific strength.

Furthermore, according to the sheet for photosemiconductor encapsulation of the invention, separation of the release sheet may be performed after pressure molding, that is to say, at any time from after encapsulation of the light-emitting device to immediately before use thereof. Accordingly, when the release sheet is separated after the light-emitting device is mounted, the release sheet serves as a cover sheet for the encapsulating resin layer, thereby being able to prevent breakage due to external force to the encapsulating resin layer during mounting.

Still further, the concave-convex shape in the sheet for photosemiconductor encapsulation of the invention is formed together at the time of sheet formation, so that it can be formed more easily, compared to conventional methods in which molding treatment is performed to a resin layer after encapsulation by using a mold. Specifically, for example, when the concave-convex shape is formed on an encapsulating resin surface of a light-emitting element package having a convex shape or a curved surface by the conventional methods using the mold, the concave-convex shape can only be formed on an upper surface of the encapsulating resin, because the mold is a flat plate. On the other hand, the sheet of the invention can be laminated, and pressure-molded to a shape of the light-emitting element package, so that the concave-convex shape can be formed not only on the upper surface of the encapsulating resin, but also on a side surface thereof.

The release sheet in the invention includes the concave-convex portion-forming layer having the concave shape and/or the convex shape, at the interface with the encapsulating resin layer, and is not particularly limited, as long as it can be separated after compression molding. As specific examples thereof, there are exemplified, for example, sheets made of materials having a relatively low surface free energy such as polystyrene (surface free energy: 33 mJ/m$^2$), polypropylene (surface free energy: 29 mJ/m$^2$) and polyethylene (surface free energy: 31 mJ/m$^2$). Such sheets are excellent in releasability of the sheets themselves, even when they have a monolayer structure of a concave portion-forming layer or a convex portion-forming layer composed of the above-mentioned material. Incidentally, the term "releasability" in the invention means both of releasability from the encapsulating resin layer and releasability from the mold at the time of compression molding.

Even when the sheet is constituted by a material other than the above-mentioned materials, releasability of the sheet itself can be improved by performing release treatment to a surface of the sheet.

As a method of the release treatment, there is exemplified, for example, a method of applying a release agent such as Optool HD 2010 manufactured by Daikin Industries, Ltd. or Novec EGC 1720 manufactured by 3M Ltd. to the surface of the sheet, followed by drying.

Further, as another embodiment, the release sheet may have a multilayer structure further containing the support layer in addition to the above-mentioned concave-convex portion-forming layer, from the viewpoints of improving transferability of the concave-convex shape to the concave-convex portion-forming layer and improving releasability as the whole release sheet. As materials constituting the concave-convex portion-forming layer in the multilayer structure, there are exemplified a silicone resin (surface free energy: 20 mJ/m$^2$), a fluororesin (surface free energy: 18 mJ/m$^2$) and the like, in addition to the materials constituting the above-mentioned monolayer structure. Furthermore, an UV-curable or heat-curable fluororesin-based resin (for example, perfluoropolyester) may be used. Materials for the support layer include polyethylene terephthalate, polypropylene resins, metal foil and the like.

Such a sheet may be prepared using the above-mentioned material according to a known method, but a commercially available one may be used. The commercially available products include "CR-4500" and "Difaren" manufactured by DIC Corporation, which include polystyrene as a constituent component; "CP-40" manufactured by Tohcello Co., Ltd., "3701J" manufactured by Toray Advanced Film Co., Ltd. and "Torefan" manufactured by Toray Industries, Inc., which include polypropylene as a constituent component; "Upirex" manufactured by Ube Industries, Ltd., which include a polyimide as a constituent component; "Sylgard 184" manufactured by Du Pont-Toray Co., Ltd., which include a silicone elastomer as a constituent component; and "Eval" manufactured by Kuraray Co., Ltd., which include an ethylene-vinyl alcohol copolymer as a constituent component.

In the case of the monolayer structure, methods for forming the concave-convex shape on the release sheet include, for example, a method of laminating a planar mold having the concave-convex shape on any one of sheet surfaces formed by applying a constituent resin to an appropriate thickness and drying it by heating, and performing transfer by intermittent feed using a hot press, an UV curing press or the like, and a method of performing transfer from a roll having the concave-convex shape on a surface thereof, using a roll emboss hot press.

Further, when the release sheet has the multilayer structure, what is necessary is just to laminate a constituent resin layer of the concave-convex portion-forming layer and the support layer with each other, followed by pressing with a hot press or the like, and thereafter, to form the concave-convex shape by the above-mentioned method. Alternatively, after coating of the constituent resin of the concave-convex portion-forming layer on the support layer and formation of the concave-convex portions with the roll emboss hot press, curing may also be performed by UV irradiation.

Incidentally, when a commercially available sheet is used, the concave-convex shape can be formed on any one of surfaces of the commercially available sheet in the same manner as described above.

The concave-convex shape of the release sheet is fitted to the concave-convex shape of the encapsulating resin layer, so that the shape of the concave-convex shape is preferably a shape having an effect of improving luminance of the encapsulating resin layer, such as a hemispheric lens shape, a pyramid shape, a cone shape or a bell shape.

Further, it is preferred that the concave-convex shape has a uniform fine structure, from the viewpoint of increasing a light which passes through at an angle of a critical angle or less, which is based on the difference in refractive index at an interface between the encapsulating resin layer and the air. Further, from the viewpoints of decreasing internal reflection due to Fresnel reflection and more increasing the critical angle than in the case where the interface is flat, the diameter of the concave-convex shape is preferably smaller than the wavelength of the light, and the variation in the height of the convex portions or the depth of the concave portions is preferably within $\pm 5\%$. Specifically, the diameter of the concave-convex shape is preferably from 100 nm to 10 $\mu$m, more preferably from 100 to 350 nm, and still more preferably from 150 to 300 nm. The lower limit of pitch is preferably 120 nm, more preferably 150 nm, and still more preferably 200 nm. On the other hand, the upper limit of pitch is preferably 12 $\mu$m, more preferably 450 nm, and still more preferably 350 nm. Incidentally, the pitch is preferably from 105 to 200%, more preferably from 105 to 150%, and still more preferably from 105 to 125%, compared to the diameter of the concave-convex shape. The height of the convex portions and/or the depth of the concave portions is/are preferably from 100 nm to 5 $\mu$m, more preferably from 100 to 350 nm, and still more preferably from 150 to 300 nm.

With respect to the thickness of the release sheet, in the case of the monolayer structure, the thickness is preferably from 12 to 65 $\mu$m, more preferably from 18 to 50 $\mu$m, and particularly preferably from 25 to 40 $\mu$m, from the viewpoints of followability and operability (handleability) at the time of molding. Further, in the case of the multilayer structure, the thickness of the concave-convex portion-forming layer is preferably from 0.5 to 100 $\mu$m, more preferably from 0.5 to 20 $\mu$m, and particularly preferably from 0.5 to 10 $\mu$m, from the viewpoints of followability at the time of molding and coatability and deformability of the encapsulating resin layer. In this specification, the thickness of the release sheet having the concave-convex shape means the thickness from a top portion of the concave-convex shape to an opposite face of the sheet, and the thickness of the concave-convex portion-forming layer means the thickness from a top portion of the concave-convex shape to the support layer. Incidentally, after one sheet having a thickness within the above-mentioned range is formed by laminating a plurality of the resulting sheets, followed by hot pressing, the concave-convex shape can also be formed.

The storage modulus of the release sheet within the temperature range of 80 to 150°C is preferably 10 MPa or more, and more preferably 50 MPa or more, from the viewpoint of maintaining the concave-convex shape transferred from the mold. Further, from the viewpoint of followability to the mold at the time of forming the concave-convex shape, it is preferably 1,000 MPa or less, more preferably 500 MPa or less, and still more preferably 100 MPa or less. More specifically, it is preferably within the range of 10 to 1,000 MPa, and more preferably within the range of 50 to 100 MPa. Further, the storage modulus of the release sheet at 150°C is also preferably within the same range as described above. Incidentally, in this specification, the storage modulus of the sheet can be measured according to a method described in the later-described Examples.

Further, the sheet elongation of the release sheet at 150°C is preferably 5.00% or less, and more preferably 3.00% or less, from the viewpoint of maintaining the concave-convex shape transferred from the mold. Incidentally, in this specification, the sheet elongation can be measured according to a method described in the later-described Examples.

The resin used for the encapsulating resin layer in the invention is not particularly limited, as long as it is a resin which has hitherto been used for photosemiconductor encapsulation, such as an epoxy resin, triacetyl cellulose (TAC), polycarbodiimide or a modified polyaluminosiloxane resin. However, from the viewpoint that encapsulation can be performed without breakage to the photosemiconductor element and a wiring connected to the element at the time of encapsulation processing, it is preferably a resin having a softening point of preferably 80 to 160°C, more preferably 100 to 150°C.

Further, the encapsulating resin layer in the invention may include a concave-convex portion-forming layer having a convex shape fitted to the concave shape of the release sheet and/or a concave shape fitted to the convex shape of the release sheet. Examples of the concave-convex portion-forming layers include a sheet having a storage modulus at 20°C of preferably 6 MPa or more, from the viewpoint of maintaining the concave-convex shape, and further include one having a storage modulus of preferably 1,500 MPa or less, more preferably 1,200 MPa or less, still more preferably 500 MPa or less, from the viewpoint of followability to the mold. When the storage modulus is 6 MPa or more, the concave-convex shape exposed after separation of the release sheet is not collapsed, and adjacent concave and convex portions are not fusion bonded to each other. This is therefore preferred. Further, when it is 1,500 MPa or less, followability to the mold is good, and the concave-convex shape of the mold can be accurately reproduced. This is therefore preferred. Accordingly, the storage modulus of the concave-convex portion-forming layer of the encapsulating resin layer in the invention is preferably from 6 to 1,500 MPa, more preferably from 6 to 1,200 MPa, and still more preferably from 6 to 500 MPa. Incidentally, in the invention, the storage modulus of the sheet can be measured according to a method described in the later-described Examples.

The sheets having such characteristics include, for example, a sheet prepared by using a silicone resin, an epoxy resin, polyethylene, polystyrene and the like, alone or in combination of two or more thereof. The concave-convex shape is formed on the above-mentioned sheet to form the concave-convex portion-forming layer. However, from the viewpoint of excellent flexibility, the encapsulating resin layer in the invention may have a monolayer structure including the concave-convex portion-forming layer constituted by the above-mentioned resin.

Further, from the viewpoints of improving transferability of the concave-convex shape to the concave-convex portion-forming layer and embedding the photosemiconductor element without breakage, the encapsulating resin layer may further include an element embedding layer, in addition to the above-mentioned concave-convex portion-forming layer, to form a multilayer structure. The resin constituting the element embedding layer is not particularly limited, as long as it is a resin which has hitherto been used for photosemiconductor encapsulation, such as an epoxy resin, triacetyl cellulose (TAC), polycarbodiimide or a modified polyaluminosiloxane resin.

Furthermore, in addition to the above-mentioned constituent resin, additives such as phosphors, curing agents, curing accelerators, aging inhibitors, modifiers, surfactants, dyes, pigments, discoloration inhibitors and UV absorbers may be incorporated as raw materials into the encapsulating resin layer. Incidentally, when the encapsulating resin layer includes the concave-convex portion-forming layer and the element embedding layer, the above-mentioned additives may be contained in any one of the concave-convex portion-forming layer and the element embedding layer.

As a method for forming the encapsulating resin layer having the concave-convex shape, the encapsulating resin layer having the concave-convex shape may be prepared separately from the release sheet obtained above. However, in that case, when the sheet for photosemiconductor encapsulation of the invention is prepared, the release sheet and the encapsulating resin layer are required to be laminated with each other to fit the concave-convex shape of the release sheet and the concave-convex shape of the encapsulating resin layer to each other. However, fitting of that structure is not easy because of their fine structure. Accordingly, a method is preferred in which the encapsulating resin layer is fitted to the release sheet, utilizing the concave-convex shape of the release sheet, when the concave-convex shape is formed on the encapsulating resin layer, to prepare the sheet for photosemiconductor encapsulation of the invention.

Specifically, there is performed a film forming process of directly applying a constituent resin of the encapsulating resin layer or an organic solvent solution of the resin to a surface of the release sheet on which the concave-convex shape is formed, to an appropriate thickness by a method such as casting, spin coating or roll coating, followed by drying at such a temperature that the solvent can be removed, thereby being able to obtain the sheet for photosemiconductor encapsulation of the invention in which the release sheet and the semi-cured encapsulating resin layer are fitted to each other. Incidentally, a release-treated film (for example, a film in which silicone release treatment is performed to a polyethylene terephthalate film) may be laminated and pressed at the interface between the encapsulating resin layer and the air.

Further, the semi-cured resin sheet obtained by performing the same film forming process as described above is laminated on the film to which the same release treatment as described above has been performed, allowing the resin layer to face to the surface of the release sheet on which the concave-convex shape is formed, and pressed by using a laminator or a press, thereby being able to form the sheet for photosemiconductor encapsulation of the invention, in which the concave-convex shape of the release sheet is filled with the resin layer, and the encapsulating resin layer is fitted to the release sheet.

Furthermore, when the encapsulating resin layer includes the concave-convex portion-forming layer, methods for forming the concave-convex shape on the concave-convex portion-forming layer include the same method as in the above-mentioned release sheet. However, in the preparation of the sheet for photosemiconductor encapsulation of the invention, it is necessary to fit the concave-convex shape of the release sheet and the concave-convex shape of the encapsulating resin layer to each other to laminate the release sheet and the encapsulating resin layer with each other. It is not easy to fit the sheets to each other, because of their fine structure. Accordingly, a method is preferred in which the encapsulating resin layer is fitted to the release sheet, utilizing the concave-convex shape of the release sheet, when the concave-convex shape is formed on the encapsulating resin layer, to prepare the sheet for photosemiconductor encapsulation of the invention.

Specifically, there is performed a film forming process of directly applying a constituent resin of the concave-convex portion-forming layer or an organic solvent solution of the resin to a surface of the release sheet on which the concave-convex shape is formed, to an appropriate thickness by a method such as casting, spin coating or roll coating, followed by drying at such a temperature that the solvent can be removed, thereby being able to fit the release sheet and the semi-cured concave-convex portion-forming layer to each other.

Further, for example, the semi-cured concave-convex portion-forming layer obtained by the same film forming process as described above, on which the concave-convex shape is not formed, or the semi-cured concave-convex portion-forming layer prepared by pressing the solid constituent resin, on which the concave-convex shape is not formed, is laminated on the release-treated film, allowing the above-mentioned concave-convex portion-forming layer to face to a surface of the release sheet on which the concave-convex shape is formed, and pressed thereto by using a laminator or a press, whereby the concave-convex shape of the release sheet is filled with the concave-convex portion-forming layer of the encapsulating resin layer to be able to fit the release sheet and the concave-convex portion-forming layer of the encapsulating resin layer to each other.

Incidentally, the concave-convex shape of the encapsulating resin layer is the same in shape and size as the concave-convex shape of the release sheet, because it is fitted to the concave-convex shape of the release sheet.

Further, when the encapsulating resin layer includes the concave-convex portion-forming layer and the element embedding layer, as a method for allowing the element embedding layer to be contained in the encapsulating resin layer, a constituent resin of the element embedding layer or an organic solvent solution of the resin may be applied onto the concave-convex portion-forming layer of the encapsulating resin layer to form a film, thereby performing lamination, after the concave-convex portion-forming layer of the encapsulating resin layer is fitted to the release sheet, or the concave-convex portion-forming layer of the encapsulating resin layer may be coated with the element embedding layer previously formed, followed by pressing with a hot press or the like. Incidentally, the encapsulating resin layer may include a plurality of resin layers, and resins constituting the plurality of resin layers may be the same or different.

The thickness of the encapsulating resin layer is appropriately set so that the photosemiconductor element and the wiring can be embedded, in consideration of the height of the photosemiconductor element and the height of the wiring. For example, from the viewpoint of being able to embed the photosemiconductor element and the wiring, it is preferably from 250 to 1,000 $\mu$m, more preferably from 250 to 500 $\mu$m, and still more preferably from 250 to 350 $\mu$m. In this specification, the thickness of the encapsulating resin layer having the concave-convex shape means the thickness from a top portion of the concave-convex shape to an opposite face. Incidentally, a plurality of encapsulating resin layers obtained may be laminated and hot pressed, followed by formation of the concave-convex shape, thereby forming one encapsulating resin layer having a thickness within the above-mentioned range, or the encapsulating resin layer separately prepared may be laminated on the encapsulating resin layer on which the concave-convex shape is formed, followed by hot pressing, thereby forming one encapsulating resin layer having a thickness within the above-mentioned range. In that case, constituent components of the respective encapsulating resin layers may be the same or different. For example, at least one of the plurality of encapsulating resin layers may be a phosphor-containing resin layer containing a phosphor.

The encapsulating resin layer has a melt viscosity at 150°C of preferably from 100 to 10,000 mPa·s, more preferably from 500 to 5,000 mPa·s, and still more preferably from 1,000 to 3,000 mPa·s, from the viewpoints of embedding the photosemiconductor element and the wiring at the time of encapsulation and protection from an external impact after sheet curing. Further, the storage modulus at 150°C after heat curing at 200°C for 1 hour is preferably from 10 kPa to 10 GPa, more preferably from 100 kPa to 3 GPa, and still more preferably from 1 GPa to 3 GPa. Furthermore, it is preferred that the encapsulating resin layer, above all, the encapsulating resin layer on which the concave-convex shape is formed, has a modulus of 6 MPa or more under an environment under which the release sheet is separated (for example, 25°C), in order to maintain a surface shape without the a surface portion of the encapsulating resin layer being damaged when the release sheet is separated.

In addition, the invention provides a photosemiconductor apparatus encapsulated with the sheet for photosemiconductor encapsulation of the invention.

The photosemiconductor apparatus of the invention is **characterized in that** a photosemiconductor device is encapsulated by using the sheet for photosemiconductor encapsulation of the invention. Specifically, for example, the photosemiconductor apparatus is obtained by a method including steps of laminating the above-mentioned sheet for photosemiconductor encapsulation on a substrate on which a photosemiconductor element is mounted, in such a manner that the encapsulating resin layer faces to the substrate; performing pressure molding; and then, separating a release sheet. In the photosemiconductor apparatus of the invention obtained by such a method, the concave-convex shape is formed on a surface of the encapsulating resin layer, and further, the release sheet is separated immediately before the use of the photosemiconductor apparatus. Accordingly, the concave-convex shape maintains a fine structure with no lack. Incidentally, when the sheet for photosemiconductor encapsulation of the invention is laminated on the photosemiconductor element substrate, the sheet for photosemiconductor encapsulation may be laminated after being cut in a thin rectangular shape depending on the size of the substrate.

Conditions of pressure molding are not always determined according to the kind of resin used, the sheet thickness and the like. For example, the sheet for photosemiconductor encapsulation of the invention is laminated on the photosemiconductor element mounted on the substrate, in such a manner that the encapsulating resin layer faces to the substrate on which the photosemiconductor element is mounted, thereafter, a mold is installed, and heating and pressing are performed at a temperature of preferably 80 to 160°C at a pressure of preferably 0.1 to 0.5 MPa, more preferably 0.1 to 0.3 MPa, thereby obtaining a pressure-molded package. Pressure molding under the above-mentioned conditions causes no damage to the photosemiconductor element and excellent stress relaxation of the encapsulating resin after curing.

After pressure molding, standing is performed until the shape becomes unchanged even under room temperature, and then, the mold is removed. Curing (post-curing) of the encapsulating resin layer is performed, and then, the release sheet is separated. Incidentally, post-curing can be performed, for example, preferably by standing for 15 minutes to 6 hours preferably in a drier at a temperature of 100 to 150°C.

The photosemiconductor apparatus of the invention includes the sheet for photosemiconductor encapsulation of the invention excellent in light extraction efficiency as a photosemiconductor element-encapsulating material, so that it becomes possible to take out a light in a high light-emitting luminance state, even in a photosemiconductor apparatus on which a high-intensity LED element such as a blue element, a green LED element or the like is mounted, and it can be suitably used. Further, when the phosphor is blended in the encapsulating resin layer, it is possible to take out a light in a high light-emitting luminance state, even in a photosemiconductor apparatus on which a white LED element is mounted.

Examples

The invention will be described below with reference to examples, but the invention should not be construed as being limited to these examples and the like.

Molecular Weight of Resin

The molecular weight was determine in terms of polyethylene by gel permeation chromatography (GPC).

Reflective Index of Resin

The reflective index at 25°C and 460 nm was measured by using a prism coupler (SPA-4000, manufactured by Sairon Technology, Inc.).

Example 1

A convex mold in which convex portions having a diameter of 200 nm and a height of 210 nm were arranged at 250-nm pitches was placed on a non-stretched polypropylene film (manufactured by Tohcello Co., Ltd., trade name: "S-40", 40 μm), and press molding was performed by using a vacuum press apparatus (manufactured by Nichigo-Morton Co., Ltd., V-130) under a pressure of 1 MPa at a temperature of 160°C for 3 minutes to obtain a release sheet (thickness: 40 μm) having a concave shape on a surface thereof.

Then, 600 g (0.200 mol) of a dual-end silanol type silicone oil (manufactured by Shin-Etsu Chemical Co., Ltd., trade name: "KF-9701", average molecular weight: 3,000) and 8.22 g (40.2 mmol) of aluminum isopropoxide were stirred and mixed at room temperature (25°C) for 24 hours. Thereafter, the resulting mixture was centrifuged to remove impurities, and concentrated under reduced pressure at 50°C for 2 hours to obtain a polyaluminosiloxane oil. To 100 parts by weight of the resulting polyaluminosiloxane oil, 10 parts by weight of a methacrylic silane coupling agent (manufactured by Shin-Etsu Chemical Co., Ltd., KBM-503) was added, followed by stirring under reduced pressure at 80°C for 10 minutes to obtain a methacrylic-modified polyaluminosiloxane. The resulting methacrylic-modified polyaluminosiloxane was applied onto the above-obtained release sheet having the concave shape to a thickness of 300 μm by using an applicator, followed by drying at 100°C for 10 minutes to obtain a sheet for photosemiconductor encapsulation of Example 1. Incidentally, the methacrylic-modified polyaluminosiloxane had a refractive index of 1.40 for an incident light having a wavelength of 460 nm.

Example 2

A UV-curable fluororesin solution (manufactured by Asahi Glass Co., Ltd., trade name: "NIF-A1") was applied to one surface of a polyethylene terephthalate film (18 μm) to a thickness of 1 μm, and then, a convex mold in which convex portions having a diameter of 200 nm and a height of 210 nm were arranged at 250-nm pitches was placed in such a manner that the convex portions face to the fluororesin solution-coated surface. Then, an ultraviolet ray (wavelength: 365 nm) was irradiated from a side at which the polyethylene terephthalate film was exposed to cure the fluororesin, thereby obtaining a release sheet (thickness: 19 $\mu$m) having a concave shape on a surface thereof.

Next, 200 g of an epoxy resin (manufactured by Nitto Denko Corporation, trade name: "NT-8528", epoxy equivalent: 3,200) was gradually added to 200 g of methyl ethyl ketone under conditions of 50°C to obtain an epoxy resin solution having a solid concentration of 50% by weight. The resulting epoxy resin solution was applied onto the above-obtained release sheet having the concave shape to a thickness of 50 $\mu$m by using an applicator, followed by heating at 100°C for 2 minutes, and then, at 120°C for 2 minutes to obtain an epoxy resin layer fitted to the release sheet.

Further, the above-mentioned epoxy resin solution was applied onto a separately release-treated polyethylene terephthalate film to a thickness of 50 $\mu$m by using an applicator, followed by heating at 100°C for 2 minutes, and then, at 120°C for 2 minutes to obtain one epoxy resin sheet. Further, four epoxy resin sheets were similarly prepared, and a total of 5 epoxy resin sheets were laminated on the above-obtained epoxy resin layer fitted to the release sheet by using a laminator (manufactured by Nitto Seiki Co., Ltd., NLE-550ST) at 120°C and 0.3 MPa to obtain a sheet for photosemiconductor encapsulation of Example 2. Incidentally, the epoxy resin had a refractive index of 1.55 for an incident light having a wavelength of 460 nm.

Example 3

A convex mold in which convex portions having a diameter of 10 $\mu$m and a height of 5 $\mu$m were arranged at 12-$\mu$m pitches was placed on the same non-stretched polypropylene film as used in Example 1, and press molding was performed by using the vacuum press apparatus (V-130) under a pressure of 1 MPa at a temperature of 160°C for 3 minutes to obtain a release sheet (thickness: 40 $\mu$m) having a concave shape on a surface thereof.

Next, an epoxy resin sheet (thickness: 50$\mu$m) was prepared in the same manner as in Example 2, and then, 5 epoxy resin sheets were laminated on the above-obtained release sheet having the concave shape by using the laminator (NLE-550ST) at 120°C and 0.3 MPa to obtain a sheet for photosemiconductor encapsulation of Example 3.

Comparative Examples 1 to 3

Sheets for photosemiconductor encapsulation of Comparative Examples 1 to 3 were prepared in the same manner as in Examples 1 to 3, respectively, with the exception that no concave shape was formed on the release sheet.

Array Package

The resulting sheet for photosemiconductor encapsulation was laminated on a planar substrate on which a photosemiconductor element (wavelength region: 460 nm) was mounted, in such a manner that the encapsulating resin layer faced to the photosemiconductor element, and a SUS mold having concave portions (8 mmx8 mm, depth: 250 $\mu$m) was placed thereon, followed by heating by using the vacuum press apparatus (V-130) under a pressure of 0.1 MPa at 160°C for 5 minutes. After being taken out from the vacuum laminator and being returned to room temperature (25°C), the mold was removed, and post curing was performed for 1 hour in a dryer of 150°C. Thereafter, the release sheet was separated to obtain an array package. For each of the array packages of Comparative Examples 1 to 3, the convex mold having the convex structure, which was used in molding the sheets for photosemiconductor encapsulation of Examples 1 to 3, was placed on the encapsulating resin layer, and press molding was performed by using the vacuum press apparatus (V-130) under a pressure of 0.1 MPa at 160°C for 3 minutes to form a concave shape on a surface thereof.

For the resulting array packages, light extraction efficiency was evaluated according to Test Example 1. The results thereof are shown in Table 1.

Test Example 1 (Light Extraction Efficiency)

The light-emitting luminance of each array package was measured by all-weather luminance measurement. For the array packages of Example 1 and Comparative Example 1, there was calculated the progress rate of the light-emitting luminance at the time when the array package of Comparative Example 1 in which the encapsulating resin layer had no concave shape was used as a standard. For the array packages of Example 2 and Comparative Example 2, there was calculated the light-emitting luminance progress rate at the time when the array package of Comparative Example 2 in which the encapsulating resin layer had no concave shape was used as a standard. For the array packages of Example 3 and Comparative Example 3, there was calculated the progress rate of the light-emitting luminance at the time when the array package of Comparative Example 3 in which the encapsulating resin layer had no concave shape was used as a standard. Incidentally, an integrating sphere was used for the measurement, and the measurement was made by using a multiple photometric system (MCPD-3000, manufactured by Otsuka Electronics Co., Ltd.).

Table 1

| | Encapsulating Resin Layer | Convex Portions of Encapsulating Resin Layer | Luminance Progress Rate (%) |
|---|---|---|---|
| Example 1 | Methacrylic-modified polyaluminosiloxane | Diameter: 200 nm, height: 210 mn, pitch: 250 nm | 2.3 |
| Comparative Example 1 | Methacrylic-modified polyaluminosiloxane | Diameter: 200 nm, height: 210 nm, pitch: 250 nm | 2.0 |
| Example 2 | Epoxy resin | Diameter: 200 nm, height: 210 nm, pitch: 250 nm | 12.0 |
| Comparative Example 2 | Epoxy resin | Diameter: 200 nm, height: 210 nm, pitch: 250 nm | 10.5 |
| Example 3 | Epoxy resin | Diameter: 10 μm, height: 5 μm, pitch: 12 μm | 8.0 |
| Comparative Example 3 | Epoxy resin | Diameter: 10 μm, height: 5 μm, pitch: 12 μm | 7.5 |

As a result, the array packages of Examples 1 to 3 have a higher luminance progress rate than the array packages of Comparative Examples 1 to 3, because the convex structure of the encapsulating resin layer is also formed on a side surface of the light-emitting element.

Storage Modulus of Sheet

For a sample having a width of 10 mm, a length of 15 mm and a thickness of 0.1 mm, measurement was made by using a viscoelasticity measuring instrument (DMS 210U, manufactured by Seiko Instruments Inc.) under conditions of a frequency of 10 Hz and a measurement temperature range of 34 to 170°C, and the storage modulus at 80°C and 150°C was measured.

Sheet Elongation

For a sample having a width of 5 mm, a length of 20 mm and a thickness of 0.1 mm, the length before and after a load of 2 g was loaded was measured by using a thermomechanical analyzer (TMA/SS-350, manufactured by Seiko Instruments Inc.) under conditions of 150°C, and the elongation (%) [(length after loading/length before loading) ×100-100] was calculated.

Examples 4 to 7 and Comparative Examples 4 to 6

Release Sheet A

A concave mold (mold 1) in which concave portions having a diameter of 200 nm and a height of 210 nm were arranged at 250-nm pitches was placed on a constituent sheet shown in Table 2, and press molding was performed by using the vacuum press apparatus (manufactured by Nichigo-Morton Co., Ltd., V-130) under a pressure of 1 MPa at a temperature of 160°C for 3 minutes to obtain release sheet A (thickness: 40 μm) having a concave shape on a surface thereof.

Release Sheet B

A concave mold (mold 2) in which concave portions having a diameter of 10 μm and a height of 5 μm were arranged at 12-μm pitches was placed on a constituent sheet shown in Table 2, and press molding was performed by using the vacuum press apparatus (V-130) in the same manner as in release sheet A to obtain release sheet B (thickness: 40 μm) having a concave shape on a surface thereof.

Encapsulating Resin Layer

To a mixture of 3.4 g of a vinylmethylsiloxane-dimethylsiloxane copolymer (manufactured by Gerest Inc., trade name: "VDT-731"), 5 μL of 2,4,6,8-tetramethyltetravinylcyclotetrasiloxane (manufactured by Shin-Etsu Chemical Co., Ltd., trade name: "LS-8670") and 18 μL of a platinum catalyst (manufactured by Gerest Inc., trade name: "6831.2"), 1.0 g of a hydromethylsiloxane-dimethylsiloxane copolymer (manufactured by Gerest Inc., trade name: "HMS-301") was added, followed by stirring and mixing at 25°C for 5 hours to prepare a resin solution of an encapsulating resin layer comprising a polysiloxane as a constituent resin.

Sheet for Photosemiconductor Encapsulation

The resulting resin solution of the encapsulating resin layer was applied to the surface having the concave shape of release sheet A or release sheet B obtained above to a thickness of 300 μm by using an applicator, followed by drying at 60°C for 10 minutes to obtain sheet A for photosemiconductor encapsulation having release sheet A or sheet B for photosemiconductor encapsulation having release sheet B.

Each sheet for photosemiconductor encapsulation obtained was laminated on a planar substrate on which a photosemiconductor element (wavelength region: 460 nm) was mounted, in such a manner that the encapsulating resin layer faced to the photosemiconductor element, and the SUS mold having concave portions (8 mm×8 mm, depth: 250 μm) was placed thereon, followed by heating by using the vacuum press apparatus (V-130) under a pressure of 0.1 MPa at 160°C for 5 minutes. After being taken out from the vacuum press apparatus and being returned to room temperature (25°C) to come into a state where the sheet for photosemiconductor encapsulation after molding was not deformed, the mold was removed, and post curing was performed for 1 hour in a dryer of 150°C. Thereafter, at a stage where the temperature was decreased to the vicinity of room temperature (25°C), the release sheet was separated to obtain array package A encapsulated with sheet A for photosemiconductor encapsulation or array package B encapsulated with sheet B for photosemiconductor encapsulation.

For the resulting release sheets (A and B) and array packages (A and B), characteristics were evaluated according to the following Test Examples 2 and 3. The results thereof are shown in Table 2.

Test Example 2 (Concave-Convex Transferability)

For the concave structure of each release sheet, it was observed by using an electron microscope (manufactured by Hitachi, Ltd., S-1500) whether transfer of the convex structure from each mold is good or not. The case where formation of the concave structure on the release sheet was observed was evaluated as "A", and the case where it was not observed was evaluated as "B".

Test Example 3 (Sheet Formability)

For each array package, the convex structure of the encapsulating resin layer exposed after separation of the release sheet was observed by using the electron microscope (manufactured by Hitachi, Ltd., S-1500). When the convex structure was observed, sheet formability was evaluated as "A", and when not observed, sheet formability was evaluated as "B".

Table 2

| | Release Sheet | | | | | Characteristics | | | |
|---|---|---|---|---|---|---|---|---|---|
| | Constituent Sheet | Storage Modulus (MPa) | | Elongation (%) | Encapsulating Resin Layer | Release Sheet A | Array Package A | Release Sheet B | Array Package B |
| | | 80 (°C) | 150 (°C) | | | Concave-Convex Transferability | Sheet Formability | Concave-Convex Transferability | Sheet Formability |
| Example 4 | CP-40 | 340 | 63 | 5.00 | Polysiloxane | A | A | A | A |
| Example 5 | 3701J | 330 | 93 | 4.60 | Polysiloxane | A | A | A | A |
| Example 6 | CR-4500 | 3000 | 30 | 4.95 | Polysiloxane | A | A | A | A |
| Example 7 | Difaren | 390 | 12 | 4.30 | Polysiloxane | A | A | A | A |
| Comparative Example 4 | Torefan | 4800 | 4100 | 0 | Polysiloxane | B | - | B | - |
| Comparative Example 5 | Sylgard 184 | 4.8 | 3 | 100 | Polysiloxane | B | - | A | B |
| Comparative Example 6 | Eval | <2.3 | <1 | 100< | Polysiloxane | A | B | A | B |

| * Constituent Sheet Details of Release Sheet | | |
|---|---|---|
| Trade Name | Constituent Resin | Name of Manufacturer |
| CP-40 | Polypropylene | Manufactured by Tohcello Co., Ltd. |
| 3701J | Polypropylene | Manufactured by Toray Advanced Film Co., Ltd. |
| CR-4500 | Polystyrene | Manufactured by DIC Corporation |
| Difaren | Polystyrene | Manufactured by DIC Corporation |
| Torefan | Polypropylene | Manufactured by Toray Industries, Inc. |
| Sylgard 184 | Cured product of silicone elastomer | manufactured by Du Pont-Toray Co., Ltd. |
| Eval | Ethylene-vinyl alcohol copolymer | Manufactured by Kuraray Co., Ltd. |

The results have revealed that the good concave-convex shape is formed on the release sheets in the sheets for photosemiconductor encapsulation of Examples 4 to 7, even when the convex portions of the mold are different in size. Further, it has been confirmed that in the array package encapsulated by using the sheet for photosemiconductor encapsulation having such a release sheet, the concave-convex shape is formed on the encapsulating resin layer without breakage.

Storage Modulus of Sheet

For a sample having a width of 10 mm, a length of 15 mm and a thickness of 0.1 mm, the storage modulus at 20°C was measured by using a viscoelasticity measuring instrument (DMS 210U, manufactured by Seiko Instruments Inc.) under conditions of a frequency of 10 Hz.

Example 8

Release Sheet

A convex mold in which convex portions having a diameter of 160 nm and a height of 260 nm were arranged at 250-nm pitches was placed on a non-stretched polypropylene film (manufactured by Tohcello Co., Ltd., trade name: "S-40", 40 $\mu$m), and press molding was performed by using the vacuum press apparatus (manufactured by Nichigo-Morton Co., Ltd., V-130) under a pressure of 1 MPa at a temperature of 160°C for 5 minutes to obtain a release sheet (thickness: 40 $\mu$m) having a concave shape on a surface thereof.

Encapsulating Resin Layer

To a mixture of 3.4 g of a vinylmethylsiloxane-dimethylsiloxane copolymer (manufactured by Gerest Inc., trade name: "VDT-731"), 5 $\mu$L of 2,4,6,8-tetramethyltetravinylcyclotetrasiloxane (manufactured by Shin-Etsu Chemical Co., Ltd., trade name: "LS-8670") and 18 $\mu$L of a platinum catalyst (manufactured by Gerest Inc., trade name: "6831.2"), 1.0 g of a hydromethylsiloxane-dimethylsiloxane copolymer (manufactured by Gerest Inc., trade name: "HMS-301") was added, followed by stirring and mixing at 0°C for 5 minutes to prepare a polysiloxane oil (resin A) as a constituent resin of a concave-convex portion-forming layer.
Then, 600 g (0.200 mol) of a dual-end silanol type silicone oil (manufactured by Shin-Etsu Chemical Co., Ltd., trade name: "KF-9701", average molecular weight: 3,000) and 8.22 g (40.2 mmol) of aluminum isopropoxide were stirred and mixed at room temperature (25°C) for 24 hours. Thereafter, the resulting mixture was centrifuged to remove impurities, and concentrated under reduced pressure at 50°C for 2 hours to obtain a polyaluminosiloxane oil. To 100 parts by weight of the resulting polyaluminosiloxane oil, 10 parts by weight of a methacrylic silane coupling agent (manufactured by Shin-Etsu Chemical Co., Ltd., KBM-503) was added, followed by stirring under reduced pressure at 80°C for 10 minutes to obtain a methacrylic-modified polyaluminosiloxane as a constituent resin of an element embedding layer.
The resulting polysiloxane oil was applied to the surface having the concave shape of the above-obtained release sheet to a thickness of 50 $\mu$m by using an applicator, followed by drying at 60°C for 10 minutes to prepare a sheet-shaped encapsulating resin layer (concave-convex portion-forming layer).

Sheet for Photosemiconductor Encapsulation

Then, the resulting methacrylic-modified polyaluminosiloxane was applied onto the concave-convex portion-forming layer to a thickness of 210 $\mu$m by using an applicator, followed by drying at 100°C for 10minutes to obtain a sheet for photosemiconductor encapsulation.

Example 9

In place of preparing the polysiloxane oil and applying it as the concave-convex portion-forming layer of the encapsulating resin layer to the surface having the concave shape of the release sheet to fit the release sheet and the encapsulating resin layer to each other in Example 8, granular low density polyethylene (manufactured by Japan Polyethylene Corporation, trade name: "LF 400C") was pressed under a pressure of 0.2 MPa at 100°C for 5 minutes to prepare a polyethylene sheet (resin B, thickness: 50 $\mu$m), and then, the surface having the concave shape of the release sheet of Example 8 was coated with the above-mentioned polyethylene sheet, followed by press molding under a pressure of 0.5 MPa at 160°C for 5 minutes to fit the release sheet and the concave-convex portion-forming layer of the encapsulating resin layer to each other. Except for this, the methacrylic-modified polyaluminosiloxane was applied onto the polyethylene sheet in the same manner as in Example 8 to obtain a sheet for photosemiconductor encapsulation.

Example 10

A sheet for photosemiconductor encapsulation was obtained in the same manner as in Example 8 with the exception that an epoxy resin (resin C) prepared by mixing and stirring 5 g of Epicoat 828 (manufactured by Japan Epoxy Resins Co., Ltd.), 5 g of Rikacid MH-700 (manufactured by New Japan Chemical Co., Ltd.) and 0.1 g of Curezol 2PZ (manufactured by Shikoku Chemicals Corporation) at 20°C for 10 minutes was used as the concave-convex portion-forming layer of the encapsulating resin layer in Example 8, in place of the polysiloxane oil.

Example 11

A sheet for photosemiconductor encapsulation was obtained in the same manner as in Example 9 with the exception that polystyrene (manufactured by Okura Industrial Co., Ltd., trade name: "Cellomer S-2") was used as the concave-convex portion-forming layer of the encapsulating resin layer in Example 9, in place of the polyethylene sheet.

Comparative Example 7

A sheet for photosemiconductor encapsulation was obtained in the same manner as in Example 8 with the exception that a silicone elastomer (manufactured by Wacker Asahikasei Silicone Co., Ltd., trade name: "Elastosil LR7665") was used as the concave-convex portion-forming layer of the encapsulating resin layer in Example 8, in place of the polysiloxane oil, and applied to the surface having the concave shape of the release sheet to a thickness of 50 $\mu$m by using an applicator, followed by drying at 100°C for 30 minutes, and then, at 160°C for 2 hours to prepare a sheet-shaped encapsulating resin layer (concave-convex portion-forming layer).

Comparative Example 8

A sheet for photosemiconductor encapsulation was obtained in the same manner as in Example 8 with the exception that a silicone elastomer (manufactured by Dow Corning Toray Co., Ltd., trade name: "OE-6336") was used as the concave-convex portion-forming layer of the encapsulating resin layer in Example 8, in place of the polysiloxane oil, and applied to the surface having the concave shape of the release sheet to a thickness of 50 $\mu$m by using an applicator, followed by drying at 150°C for 1 hour to prepare a sheet-shaped encapsulating resin layer (concave-convex portion-forming layer).

After the preparation of array packages with respect to the resulting sheets for photosemiconductor encapsulation, light extraction efficiency was evaluated according to the following Test Example 4. Further, the height of convex portions of the encapsulating resin layers on the resulting array packages was measured by using an electron microscope (manufactured by Hitachi High-Technologies Corporation, SU-1500). The results thereof are shown in Table 3.

Array Package

Each sheet for photosemiconductor encapsulation obtained was laminated on a planar substrate on which a photosemiconductor element (wavelength region: 460 nm) was mounted, in such a manner that the encapsulating resin layer faced to the photosemiconductor element, and the SUS mold having concave portions (8 mmx8 mm, depth: 250 $\mu$m) was placed thereon, followed by heating by using the vacuum press apparatus (V-130) under a pressure of 0.1 MPa at 80°C for 15 minutes. After being taken out from the vacuum press apparatus and being returned to room temperature (25°C) to come into a state where the sheet for photosemiconductor encapsulation after molding was not deformed, the mold was removed, and post curing was performed in a dryer of 150°C, for 2 hours in the case where each of the sheets of photosemiconductor encapsulation of Examples 8 and 10 and Comparative Examples 7 and 8, and for 1 hour in the case where each of the sheets of photosemiconductor encapsulation of Examples 9 and 11. Thereafter, at a stage where the temperature was decreased to room temperature (25°C), the release sheet was separated to obtain an array package.

Test Example 4 (Light Extraction Efficiency)

The light-emitting luminance of each array package was measured by all-weather luminance measurement. On the other hand, an array package (Reference Example) was prepared by using a sheet for photosemiconductor encapsulation prepared in the same manner as described above with the exception that the release sheet and the encapsulating resin layer had no concave-convex shape, although the constituent resins thereof were the same. On the basis of the array package thus prepared, the progress rate of the light-emitting luminance was calculated by the following equation to evaluate light extraction efficiency. Incidentally, an integrating sphere was used for the light-emitting luminance measurement, and the measurement was made by using the multiple photometric system (MCPD-3000, manufactured by Otsuka Electronics Co., Ltd.).

$$\text{Progress rate of light-emitting luminance (\%)} = (\text{luminance of Example or Comparative Example/luminance of Reference Example}) \times 100 - 100$$

Table 3

| | Sheet for Photosemiconductor Encapsulation | | | | | Array Package | |
|---|---|---|---|---|---|---|---|
| | Release Sheet | Encapsulating Resin Layer | | | | Encapsulating Resin Layer | Progress Rate of Light-Emitting Luminance (%) |
| | | Concave-Convex Portion Forming Layer | | Element Embedding Layer | | | |
| | | Constituent Resin | Modulus (MPa) | Constituent Resin | | Height of Convex Portion ($\mu$m) | |
| Example 8 | Polypropylene film | Resin A (polysiloxane) | 6.4 | Methacrylic-modified polyaluminosiloxane | | 202 | 3.0 |
| Example 9 | Polypropylene film | Resin B (polyethylene) | 42 | Methacrylic-modified polyaluminosiloxane | | 198 | 4.5 |
| Example 10 | Polypropylene film | Resin C (epoxy resin) | 507 | Methacrylic-modified polyaluminosiloxane | | 202 | 4.7 |
| Example 11 | Polypropylene film | Polystyrene | 1179 | Methacrylic-modified polyaluminosiloxane | | 254 | 5.2 |
| Comparative Example 7 | Polypropylene film | Silicone elastomer 1 | 1.7 | Methacrylic-modified polyaluminosiloxane | | 17 | 0.3 |
| Comparative Example 8 | Polypropylene film | Silicone elastomer 2 | 2.8 | Methacrylic-modified polyaluminosiloxane | | 50 | 0.5 |
| Polystyrene: Cellomer S-2 manufactured by Okura Industrial Co., Ltd. Silicone elastomer 1: Elastosil LR7665 manufactured by Wacker Asahikasei Silicone Co., Ltd. Silicone elastomer 2: OE-6336 manufactured by Dow Coming Toray Co., Ltd. | | | | | | | |

The results have revealed that the transfer of the concave-convex shape of the release sheets as the mold is good, and that the progress rate of light-emitting luminance is high, in the sheets for photosemiconductor encapsulation of Examples 8 to 11.

While the invention has been described in detail with reference to specific embodiments thereof, it will be apparent to one skilled in the art that various changes and modifications can be made therein without departing from the spirit and scope of the invention. Incidentally, this application is based on Japanese Patent Application No. 2009-033886 filed on February 17, 2009, Japanese Patent Application No. 2009-114786 filed on May 11,2009 and Japanese Patent Application No. 2009-122139 filed on May 20, 2009, the entire contents of which are incorporated herein by reference.

Further, all references cited herein are incorporated by reference in their entirety.

The sheet for photosemiconductor encapsulation of the invention is suitably used, for example, in producing backlights of liquid crystal screens, traffic signals, large outdoor displays, billboards and the like.

**Claims**

1. A sheet for photosemiconductor encapsulation comprising a release sheet and an encapsulating resin layer laminated thereon,
   wherein the release sheet comprises a concave-convex portion-forming layer having a concave shape and/or a convex shape, at an interface with the encapsulating resin layer, and the encapsulating resin layer has a convex shape fitted to the concave shape of the release sheet and/or a concave shape fitted to the convex shape of the release sheet at an interface with the release sheet.

2. The sheet for photosemiconductor encapsulation according to claim 1, wherein the release sheet has a storage modulus at 150°C of 10 to 1,000 MPa and a sheet elongation at 150°C of 5.00% or less.

3. The sheet for photosemiconductor encapsulation according to claim 1, wherein the encapsulating resin layer comprises: a concave-convex portion-forming layer having a convex shape fitted to the concave shape of the release sheet and/or a concave shape fitted to the convex shape of the release sheet; and an element embedding layer capable of embedding a photosemiconductor element,
   and wherein the concave-convex portion-forming layer of the encapsulating resin layer has a storage modulus at 20°C of 6 to 1,500 MPa.

4. The sheet for photosemiconductor encapsulation according to any one of claims 1 to 3, wherein a height of the convex portion of the convex shape and/or a depth of the concave portion of the concave shape in the encapsulating resin layer is/are from 100 nm to 10 $\mu$m.

5. The sheet for photosemiconductor encapsulation according to any one of claims 1 to 4, wherein the release sheet further comprises a support layer.

6. A photosemiconductor apparatus in which a convex shape and/or a concave shape is/are formed on a surface thereof by laminating the sheet for photosemiconductor encapsulation according to any one of claims 1 to 5 on a photosemiconductor element-mounted substrate so that the encapsulating resin layer faces to the substrate; performing pressure molding; and then, separating the release sheet.

*FIG. 1*

*FIG. 2*

*FIG. 3*

*FIG. 4*

EP 2 219 242 A2

**FIG. 5**

**FIG. 6**

**FIG. 7**

## FIG. 8

## FIG. 9

**REFERENCES CITED IN THE DESCRIPTION**

**Patent documents cited in the description**

- JP 11204840 A
- JP 2005166941 A
- JP 2007110053 A
- JP 2009033886 A
- JP 2009114786 A
- JP 2009122139 A